Europäisches Patentamt

European Patent Office

Office européen des brevets

(11) Veröffentlichungsnummer: **0 070 515**
A2

# (12) EUROPÄISCHE PATENTANMELDUNG

(21) Anmeldenummer: **82106310.4**

(22) Anmeldetag: **14.07.82**

(51) Int. Cl.³: **H 01 L 33/00**

(30) Priorität: **17.07.81 DE 3128395**

(43) Veröffentlichungstag der Anmeldung: **26.01.83**
**Patentblatt 83/4**

(84) Benannte Vertragsstaaten: **FR GB IT**

(71) Anmelder: **SIEMENS AKTIENGESELLSCHAFT, Berlin und München Wittelsbacherplatz 2, D-8000 München 2 (DE)**

(72) Erfinder: **Albrecht, Helmut, Dr., Dipl.-Ing., Thalkirchnerstrasse 66, D-8000 München 2 (DE)**
Erfinder: **Weyrich, Claus, Dr.phil., Untertaxetweg 14, D-8035 Gauting (DE)**

(54) **Lumineszenzdiode.**

(57) Zur Erhöhung der Helligkeit einer Lumineszenzdiode mit Schwefel, Tellur und/oder Selen dotierter N-leitender Zone (5) und einer angrenzenden P-leitenden Zone (6) ist die Donator-Hintergrund-Dotierung in der P-leitenden Zone (6) um wenigstens das 2fache geringer als die Donator-Dotierung der N-leitenden Zone (5).

0070515

SIEMENS AKTIENGESELLSCHAFT     Unser Zeichen
Berlin und München             VPA 81 P 7079 E

## Lumineszenzdiode.

Die vorliegende Erfindung bezieht sich auf eine Lumineszenzdiode, wie sie im Oberbegriff des Patentanspruchs 1 angegeben ist.

Lumineszenzdioden mit einem PN-Übergang zwischen einer N-leitenden Zone und einer P-leitenden Zone in einem durch Epitaxie, z.B. auf einem Galliumarsenid- oder Galliumphosphid-Substrat, hergestellten Halbleiterkörper sind bekannt. Bei der Herstellung dieses Halbleiterkörpers mit zwei Zonen ist es üblich, die auf die N-leitende Zone folgende P-leitende Zone in der Weise herzustellen, daß entweder während des Epitaxie-Vorgangs dem Halbleitermaterial mit P-dotierendem Zusatz während der Herstellung der P-leitenden Zone zusätzlich noch P-gegendotierender weiterer Zusatz hinzugefügt wird oder daß ein Anteil der N-leitenden Zone durch spätere Eindiffusion von P-dotierenden Akzeptoren unter Beibehaltung der N-Hintergrunddotierung P-leitend gemacht wird. Nach diesen Verfahren hergestellte und die Merkmale dieser Verfahrens aufweisende Lumineszenzdioden sind seit wenigstens einem Jahrzehnt bekannt.

Im vergangenen Jahrzehnt sind die verschiedensten Versuche gemacht worden, die Lumineszenzdioden bezüglich ihrer Helligkeit zu verbessern. Z.B. ist entsprechend einem relativ jungen Vorschlag aus "Jap. Journ. of Appl. Physics", Bd.19, Nr.11, Nov.1980, Seiten 2157 bis 2163 unternommen worden, der N-leitenden Zone eine stufenweise sogenannt 'graded conductivity' zu geben.

Bts 1 Bla / 15.7.1981

Man erreicht dies dadurch, daß man der N-leitenden Zone eine räumlich nicht konstante Donator-Konzentration gibt, und zwar derart, daß in der N-leitenden Zone in Schichtanteilen nahe dem zwischen der N-leitenden Zone und der P-leitenden Zone vorhandenen PN-Übergang der Grad der Donator-Dotierung vergleichsweise zu von dem PN-Übergang etwas weiter entfernt liegenden Schichtanteilen dieser N-leitenden Zone am niedrigsten ist. Dies zeigt insbesondere Fig.3 der obengenannten Druckschrift. Die P-leitende Zone ist bei dieser bekannten Diode unverändert gegenüber schon früher bekannten Dioden dotiert. Physikalisch gesehen ist bei dieser aus der obengenannten Druckschrift bekannten Diode unter der Annahme von Lichtemission aus der N-leitenden Zone nahe dem PN-Übergang für diesen Bereich somit ein niedrigerer Dotierungspegel – vergleichsweise zu höherem Dotierungspegel weiter entfernt von diesem PN-Übergang – vorgesehen.

Es ist eine Aufgabe der vorliegenden Erfindung, eine Lumineszenzdiode anzugeben, die vergleichsweise zu bekannten Typen von Lumineszenzdioden größere Helligkeit, d.h. höheren Wirkungsgrad, bei vergleichsweise gleichem Strom hat.

Diese Aufgabe wird mit einer Lumineszenzdiode nach dem Oberbegriff des Patentanspruchs 1 mit den Merkmalen des Kennzeichens dieses Anspruchs gelöst. Weitere Ausgestaltungen und Weiterbildungen der Erfindung gehen aus den Unteransprüchen hervor.

Den kennzeichnenden Merkmalen der vorliegenden Erfindung liegen Überlegungen zugrunde, die darauf hinzielen, nicht nur die Lebensdauer der Minoritäts-Ladungsträger wenigstens beizubehalten oder zu erhöhen, sondern auch den Injektions-Wirkungsgrad zu erhöhen.  Hierzu ist im Gegensatz zur Diode nach der obengenannten Druckschrift gemäß der Erfindung vorgesehen, hohe Donator- Dotierung mit Schwefel, Selen und/oder Tellur nahe dem PN-Übergang wenigstens im wesentlichen beizubehalten, jedoch die im P-leitenden Gebiet vorhandene N-Hintergrunddotierung, die bei bekannten Dioden an sich schon von der P-Akzeptor-Dotierung in dieser Zone um Größenordnungen übertroffen wird, wenigstens um den Faktor 2, besser um einen Faktor 5 bis 10, zu verringern.

Im Gegensatz zu den dem Stand der Technik zugrunde liegenden Überlegungen beruht die erfindungsgemäße Lehre nämlich auf der zusätzlichen Erkenntnis, daß eine zu starke Verminderung der Majoritätsträger-Dotierung der betreffenden Zone eine zu starke Verringerung des Grades der Ladungsträger-Injektion in die jeweils benachbarte Zone des PN-Übergangs bewirkt.

Eine weitere Steigerung der Helligkeit läßt sich bei einer Diode nach der Erfindung erreichen, wenn man die Netto-Dotierung in der N-leitenden Zone, beispielsweise durch ein erhöhtes Angebot von Schwefelwasserstoff im Epitaxie-Prozeß (im Gegensatz zur Diode nach der obengenannten Druckschrift) noch erhöht.

Weitere Erläuterungen der Erfindung gehen aus der nachfolgenden Beschreibung eines anhand der Figuren erörterten bevorzugten Ausführungsbeispiels der Erfindung hervor.

Fig.1 zeigt eine erfindungsgemäße Diode und

Fig.2 zeigt eine an sich bekannte Vorrichtung zur Ausführung der Epitaxie.

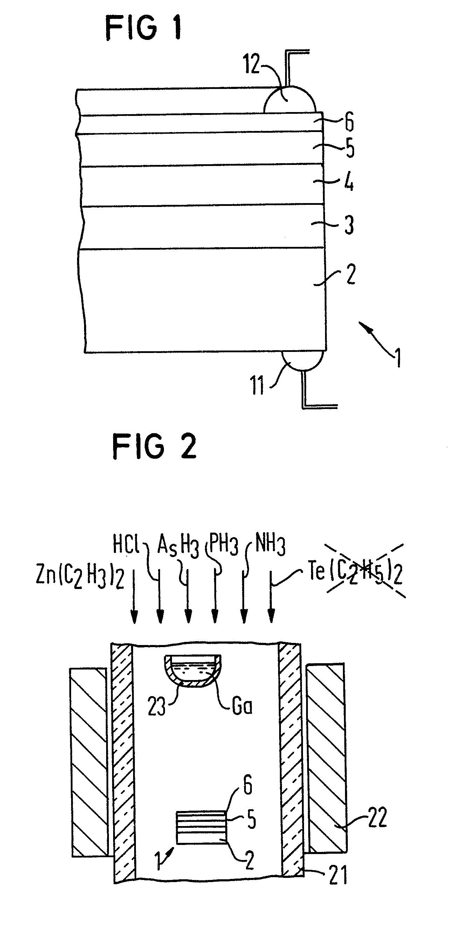

Die Fig.1 zeigt mit 1 bezeichnet eine erfindungsgemäße Lumineszenzdiode. Mit 2 ist ein Substratkörper aus III-V-Halbleitermaterial, vorzugsweise aus Galliumphosphid oder Galliumarsenid, bezeichnet. Auf diesen Substratkörper 2 wird z.B. mit Hilfe der Gasphasen-Epitaxie oder der Flüssigphasen-Epitaxie weiteres Halbleitermaterial epitaktisch abgeschieden, das insbesondere Galliumarsenid-Phosphid ist. Dieses Halbleitermaterial ist für Lumineszenzdioden mit roter, oranger und gelber Strahlung bekannt. Die Erfindung ist besonders für diese Fälle von Vorteil. Um bezüglich der Kristallperfektion möglichst gute, für die Lumineszenz relevante Epitaxie-Schichten zu erhalten, empfiehlt es sich, auf dem Substratkörper 2 zunächst zusätzlich eine erste Anpassungs-Epitaxie-Schicht 3 mit einer Dicke von z.B. 30 µm aus Galliumarsenid-Phosphid abzuscheiden, in der der Arsengehalt auf Kosten des Phosphorgehaltes von den dem Substratkörper 2 nahen Schichtanteilen zu den dem Substratkörper 2 entfernten Schichtanteilen hin zunimmt. Es ist dies also eine Epitaxie-Schicht 3 mit einem schichtweise im wesentlichen kontinuierlich anwachsenden Arsenidgehalt. Auf diese Weise erhält man in der Epitaxie-Schicht 3 eine Oberflächenschicht mit einem solchen Galliumarsenid-Phosphid, das gleich der Arsen/Phosphid-Zusammensetzung ist, die die weiteren lumineszenzrelevanten Epitaxie-Schichten vorgegebenermaßen haben.

Die folgenden Epitaxie-Schichten 4 und 5 sind ebenfalls N-leitend, haben aber konstanten Arsenidgehalt. Dabei ist für gelb und für orange leuchtende Dioden die Epitaxie-Schicht 5 gegenüber der Schicht 4 bekanntermaßen mit Stickstoff dotiert.

Die folgende, letzte Halbleiterschicht 6 der erfindungsgemäßen Lumineszenzdiode besteht wie die Schicht 5 aus Galliumarsenid-Phosphid. Für orange und für gelb leuchtende Dioden ist die Schicht 6 ebenfalls auch mit Stickstoff dotiert. Sie ist jedoch P-leitend mit vorzugsweise Zink dotiert. Im Gegensatz zum Stand der Technik ist jedoch in der Epitaxie-Schicht 6 der Gehalt an N-Leitung erzeugender Donator-Hintergrunddotierung (wie sie als Hauptdotierung in den Schichten 5 und 4 vorhanden ist) um wenigstens den Faktor 2, besser um einen Faktor 5 bis 10, niedriger als die Donator-Dotierung der Schicht 5 (und der Schicht 4).

Die Epitaxie der Schichten 3, 4 und 5 und zum Teil auch der Schicht 6 erfolgt üblicherweise so, daß aus der Flüssigphase oder aus der Gasphase Gallium, Arsen und Phosphor abgeschieden werden, und zwar für die Schichten 5 und 6 mit gegebenenfalls noch zusätzlicher Beifügung von Stickstoffgas. Die notwendige Donator-Dotierung wird durch Zugabe von Schwefel, Selen und/oder Tellur, und zwar aus der Gasphase, bewirkt. Im Gegensatz zum Stand der Technik wird aber beim Übergang von der Epitaxie der Schicht 5 zur Epitaxie der Schicht 6 vorzugsweise weitgehend abrupt die Zugabe von Donator-Dotierung vermindert oder sogar völlig abgebrochen, währenddessen die Zugabe von Akzeptor-Dotierung, vorzugsweise Zink, einsetzt. Es ergibt sich damit ein (vergleichsweise zu Lumineszenzdioden mit eindiffundierter P-leitender Zone) ganzflächiger PN-Übergang im Bereich des Übergangs zwischen N-leitender Epitaxie-Schicht 5 und P-leitender Epitaxie-Schicht 6.

In der Epitaxie-Schicht 5 ist eine Donator-Konzentration von beispielsweise $10^{15}$ bis $10^{17}$, insbesondere $5 \cdot 10^{15}$ bis $10^{17}$ Teilchen pro $cm^3$ vorgesehen. Für die Epitaxie-Schicht 6 mit P-Leitung ist eine Akzeptor-Konzentration von $10^{18}$ bis $10^{19}$, vorzugsweise $3 \cdot 10^{18}$ bis $5 \cdot 10^{18}$, Teil-

chen pro $cm^3$ vorgesehen. Die Stickstoff-Dotierung beträgt für die Schichten 5 und 6 vorzugsweise $10^{16}$ bis $10^{19}$ Teilchen pro $cm^3$. Erfindungswesentlich ist, daß in der Epitaxie-Schicht 6 mit P-Leitung die zwar ohnehin schon bekanntermaßen gegenüber der Akzeptor-Dotierung um Größenordnungen geringere Donator-(Hintergrund-)Dotierung gegenüber der Donator-Konzentration Schwefel, Selen und/oder Tellur der Epitaxie-Schicht 5 verringert ist. Bei dem Mindestfaktor 2 beträgt diese Donator-Hintergrund-Dotierung in der Schicht 6 z.B. nur noch $10^{16}$ Teilchen pro $cm^3$ bei einer Donator-Dotierung der Schicht 5 mit $2 \cdot 10^{16}$ Teilchen pro $cm^3$.

Zwecks der üblichen Stromzuführung für die Lumineszenzdiode 1 ist diese mit ohmschen Anschlußelektroden 11 und 12 an vorzugsweise dem Substratkörper 2 bzw. an der P-leitenden Epitaxie-Schicht 6 versehen. Insbesondere die Elektrode 12 kann ringförmig ausgebildet sein. Statt dessen kann auch eine Elektrode 12 auf der Epitaxie-Schicht vorgesehen sein, die ganzflächig, jedoch für die von der Diode erzeugte Lumineszenzstrahlung durchlässig ist.

Bei einem Phosphidgehalt von 65% erhält man eine erfindungsgemäße Lumineszenzdiode, die orangefarbenes Licht emittiert. Bei einem Phosphidgehalt von 85% ergibt dies eine gelb leuchtende Diode.

Gemäß einer Weiterbildung der Erfindung erhält man eine weitere Steigerung der Helligkeit der erfindungsgemäßen Diode, wenn man für die Epitaxie-Schicht 5 eine Donator-Konzentration vorsieht, die mit $10^{17}$ bis $10^{18}$ Teilchen pro $cm^3$ sogar über der oberen Grenze des für bekannte Lumineszenzdioden üblichen Maßes liegt. Speziell bei höherem Grad der N-leitenden Epitaxie-Schicht 5 kommen für die Erfindung größere Faktoren von z.B. 5 bis 10
für die Herabsetzung der Donator-Hintergrund-Dotierung
in der Epitaxie-Schicht 6 in Betracht.

Bei einer erfindungsgemäßen Diode, die durch Epitaxie ihrer
Schichten hergestellt ist und in der die P-leitende
Schicht durch Dotierung während des Epitaxie-Vorgangs
erfolgt ist, ist der aus dem Stand der Technik übliche
nachfolgende Diffusionsvorgang zur Erzeugung eines P-
leitenden Gebietes in einer N-leitenden Zone entbehrlich.

Eine erfindungsgemäße Diode kann allerdings auch unter
Anwendung eines Diffusionsprozesses für die P-leitende
Zone 6 hergestellt sein. Im Verlauf der Epitaxie-
Schritte zur Herstellung einer solchen Diode wird beim
Übergang von der Epitaxie-Schicht 5 zur Epitaxie-Schicht
6 dann lediglich der Grad der Donator-Dotierung herabgesetzt, um die erfindungsgemäß verminderte Donator-
Hintergrund-Dotierung in der Epitaxie-Schicht 6 zu erreichen. Die in der Epitaxie-Schicht 6 erforderlichen
Akzeptoren werden dann nach Abschluß der Epitaxie durch
Eindiffusion von vorzugsweise Zink hereingebracht.
Dabei besteht eine gewisse Schwierigkeit, die Eindiffusion des Zinks in der Tiefe derart gesteuert vorzunehmen,
daß wesentliche Akzeptor-Dotierung nur bis zur mehr oder
weniger scharfen Grenzfläche zwischen den Epitaxie-
Schichten 5 und 6 reicht, d.h. nur bis an denjenigen
Schichtanteil der Diode 1 reicht, in dem die Donator-
Dotierung der Epitaxie-Schicht 5 auf den Grad der Donator-Dotierung der Epitaxie-Schicht 6 erfindungsgemäß
abfällt.

Fig.2 zeigt eine an sich bekannte Vorrichtung zur Durchführung einer Epitaxie einer erfindungsgemäßen Diode.

0070515.

Mit 21 ist das als Rohrabschnitt dargestellte Reaktionsrohr bezeichnet. Das Bezugszeichen 22 weist auf einen
Rohrofen zur Erhitzung des Innenraumes des Rohres 21 hin.
Auf einer entsprechenden Unterlage liegen die Substratkörper 2 der erfindungsgemäßen Diode auf, von denen in
der Fig.2 eine einzige Diode 1 wiedergegeben ist. Mit
23 ist ein Tiegel bezeichnet, in dem sich schmelzflüssiges Gallium befindet. Vom einen Ende des Reaktionsrohres 21 her werden für die Gas-Epitaxie die einzelnen
Gase zugeführt. Der zugeführte Chlorwasserstoff HCl
dient dazu, mit dem aus dem Tiegel 23 verdampfenden
Gallium eine Verbindung einzugehen, und es dient damit
als Transportgas für das Gallium. Das Arsin $AsH_3$ und
das Phosphin $PH_3$ werden wie angedeutet zugeführt.

In der Darstellung der Fig.2 ist die Epitaxie der Diode
1 bereits soweit fortgeschritten, daß die Schichten 3
bis 5 schon vorhanden sind. Für die Schicht 5 wurde
Tellurdiäthylen $Te(C_2H_5)_2$ für die Tellur-Dotierung und
Ammoniak $NH_3$ für die Stickstoff-Dotierung zugegeben.
Für die in der Darstellung der Fig.2 gerade ablaufende
Epitaxie der Schicht 6 wird entweder keinerlei oder
nur entsprechend weniger Tellurdiäthylen zugegeben,
was durch das Durchkreuzen der entsprechenden Formel
angedeutet ist. Für die Schicht 6 wird aber eine dampfförmige zinkorganische Verbindung, wie z.B. Diäthlzink
$Zn(C_2H_5)_2$, zugegeben, das die Akzeptor-Dotierung bewirkt.
Auch während der Epitaxie der Schicht 6 wird gegebenenfalls Ammoniak zugegeben.

6 Patentansprüche
2 Figuren

Patentansprüche:

1. Lumineszenzdiode mit einer durch Donator-Dotierung erzeugten N-leitenden Zone und mit einer durch Akzeptor-Dotierung P-leitenden Zone in einem durch Epitaxie aufgebauten Halbleiterkörper aus III-V-Halbleitermaterial, an dem sich ohmsche Kontakte befinden, g e k e n n - z e i c h n e t  dadurch, daß bei einer Donator-Dotierung mit Schwefel, Tellur und/oder Selen die Donator-Hintergrund-Dotierung der P-leitenden Zone (6) einen wenigstens um einen Faktor 2 kleineren Dotierungsgrad als die Donator-Dotierung in wenigstens dem angrenzenden Bereich der N-leitenden Zone (5) hat.

2. Lumineszenzdiode nach Anspruch 1, g e k e n n - z e i c h n e t  dadurch, daß der epitaktisch aufgebaute Halbleiterkörper (3 bis 6) aus Galliumarsenid-Phosphid besteht.

3. Lumineszenzdiode nach Anspruch 2, g e k e n n - z e i c h n e t  dadurch, daß Schichten (5, 6) dieses Halbleiterkörpers mit Stickstoff (N) dotiert sind.

4. Lumineszenzdiode nach einem der Ansprüche 1 bis 3, g e k e n n z e i c h n e t  dadurch, daß der Halbleiterkörper durch Gasphasen-Epitaxie hergestellt ist.

5. Lumineszenzdiode nach einem der Ansprüche 1 bis 4, g e k e n n z e i c h n e t  dadurch, daß die P-leitende Zone (6) durch Eindiffusion der Akzeptor-Dotierung hergestellt ist.

6. Lumineszenzdiode nach einem der Ansprüche 1 bis 4, g e k e n n z e i c h n e t dadurch, daß die Akzeptor-Dotierung der P-leitenden Zone (6) dadurch erzeugt ist, daß dem Halbleitermaterial, aus dem die P-leitende Zone epitaktisch aufgebaut ist, während der Epitaxie dieser Zone (6) Akzeptor-Dotierung anstelle von Donator-Dotierung zugegeben ist, die beim zuvor erfolgten epitaktischen Aufbau der N-leitenden Zone (5) dem Halbleitermaterial zugegeben worden ist.

1/1

## FIG 1

12

6
5
4
3
2

1

11

## FIG 2

$Zn(C_2H_3)_2$   $HCl$   $A_sH_3$   $PH_3$   $NH_3$   ~~$Te(C_2H_5)_2$~~

23   Ga

6
5
2

1

22

21